# EUROPEAN PATENT APPLICATION

(11) **EP 2 161 586 A1**
(43) Date of publication of application: **10.03.2010**
(21) Application number: 08155013.9
(22) Date of filing: 23.04.2008
(51) Int. Cl.: G01R 31/04

(54) **Enhanced HDMI cable detection**

(71) Applicant: Koninklijke Philips Electronics N.V., 5621 BA Eindhoven (NL)
(72) Inventor: The designation of the inventor has not yet been filed
(74) Representative: Schoenmaker, Maarten

(57) **Abstract**

A data communication system like HDMI has a standard cable having multiple shields at the connectors being connected to respective shield pins. An enhanced cable (77) connects a first and a second shield. At one end of the cable the first shield is connected to a shield pin and the second shield is not connected to a shield pin, while at the other end of the cable the first shield is not connected to a shield pin and the second shield is connected to a shield pin. An enhanced device (76) detects a status of said shield pins being either connected to ground or being not connected and determines a connection status indicating the presence of either the standard cable or the enhanced cable connected between the enhanced device and a peer device.

## Description

### FIELD OF THE INVENTION

The invention relates to a system, comprising:
a standard cable having standard connectors, the cable comprising at least a first and a second shield, the first and second shields at the connectors being connected to respective shield pins of the connector pins,
a standard device having a receptacle for receiving one of said connectors for connecting receptacle pins to connector pins.

The invention further relates to an enhanced cable, an enhanced device, a secondary enhanced device and a method for use in the system.

The invention relates to the field of interfaces for data communication such as video and/or audio data, and in particular to HDMI (High-Definition Multimedia Interface).

### BACKGROUND OF THE INVENTION

For connecting data processing devices cables are required having predefined connectivity. The cables have connectors that are interconnected via the cable according to a predefined connector pin assignment, while the devices are provided with corresponding receptacles for receiving the connectors. Furthermore the data communication cables may be provided with a multitude of shields for reducing interference of electromagnetic radiation on sensitive communication wiring. Data communication interfaces are usually described in standardized specifications. An example of such an interface specification is [1]: the High-Definition Multimedia Interface Specification Version 1.3 of June 22, 2006, which interface is also widely known as the HDMI standard.

The HDMI standard defines a standard cable, connectors (also called plugs), and cooperation with devices, for providing an interface for audio, video, data and control.

### SUMMARY OF THE INVENTION

It is proposed to enhance an existing standard communication system, e.g. the known HDMI standard, by facilitating further information transfer via an enhanced cable and enhanced devices that are backwards compatible to the known standard. Preferably the enhanced cable is still compatible to the standard cable, while at the same time the connectivity is enhanced, e.g. by improving the data transmission parameters and/or shielding of the cable, adding extra connections, etc. However, if enhanced devices are connected via a standard cable, data communication may be disturbed. Hence there is a need to detect the presence of a particular cable to reliably transfer data according to the enhanced standard.

It is an object of the invention to provide reliable detection of an enhanced cable in a system environment where standard cables and standard devices and enhanced cables and enhanced devices are intermingled.

For this purpose, according to a first aspect of the invention, the system as described in the opening paragraph comprises:
an enhanced cable for enhanced connectivity with respect to the standard cable, having
   - connectors having respective shield pins assigned corresponding to the assignment of shield pins in the standard cable,
   - the first and second shields, the second shield being connected to the first shield,
   - the first shield at one end of the cable being connected to the first respective shield pin,
   - the second shield at said one end of the cable being not connected to the second respective shield pin,
   - the first shield at the other end of the cable being not connected to the third respective shield pin, and
   - the second shield at said other end of the cable being connected to the fourth respective shield pin; and
an enhanced device having a receptacle for receiving one of said connectors and detection means for
   - detecting, on a first receptacle pin, a first status of said first shield pin being either connected to ground or being not connected,
   - detecting, on a second receptacle pin, a second status of said second shield pin being either connected to ground or being not connected, and
   - determining a connection status indicating the presence of either the standard cable or the enhanced cable connected between the enhanced device and a peer device based on the first and second status.

For this purpose, according to a second aspect of the invention, an enhanced cable for use in the system has
- connectors having respective shield pins assigned corresponding to the assignment of shield pins in the standard cable,
- the first and second shields, the second shield being connected to the first shield,
- the first shield at one end of the cable being connected to the first respective shield pin,
- the second shield at said one end of the cable being not connected to the second respective shield pin,
- the first shield at the other end of the cable being not connected to the third respective shield pin, and
- the second shield at said other end of the cable being connected to the fourth respective shield pin.

For this purpose, according to a third aspect of the invention, an enhanced device for use in the system has a receptacle for receiving one of said connectors and detection means for
- detecting, on a first receptacle pin, a first status of said first shield pin being either connected to ground or being not connected,
- detecting, on a second receptacle pin, a second status of said second shield pin being either connected to ground or being not connected, and
- determining a connection status indicating the presence of either the standard cable or the enhanced cable connected between the enhanced device and a peer device based on the first and second status.

The measures have the effect that, when an enhanced cable is present at least one of said unconnected connector pins can be detected, while at the same time the other pin is detected to be grounded via the peer device. When a standard cable is present instead, both pins will be grounded. Advantageously the enhanced device is able to detect the difference of the cable type while at the same time the presence of the peer device is detected. Moreover due to the fact that the second shield is connected to the first shield, both shields are effectively connected to ground and can fulfill their shielding function.

The invention is also based on the following recognition. In the standard cable a multiple shields is present while each shield has shield pins assigned in both connectors. The inventors have seen that such assignment is partly redundant. By interconnecting a pair of shields and at the same time crosswise not connecting the corresponding shield pins as defined in the claims, the enhanced device can always detect the difference between three conditions:
- no cable present or no peer device connected;
- a standard cable connected to a peer device;
- an enhanced cable connected to a peer device.

In an embodiment of the enhanced cable the connectors at both sides of the cable are identical. A universal, outwardly symmetrical, cable is provided. As defined above, the shield pins of said first and second shield are crosswise not connected. Hence the cable may be connected between devices in a normal orientation or a reverse orientation. For such identical connectors the crosswise arrangement of not connected pins has the advantage that always, i.e. irrespective of the orientation of the cable, one of the first and second pins is not grounded for the enhanced cable, while both pins are grounded for the standard cable. Hence the cable type can be reliably detected by combining the first and second status. Moreover, if required, said orientation of the cable can also be detected.

In an embodiment a further enhanced cable has
- third and fourth shields, the fourth shield being connected to the third shield,
- the third shield at one end of the cable being connected to the fifth respective shield pin,
- the fourth shield at said one end of the cable being not connected to the sixth respective shield pin,
- the third shield at the other end of the cable being not connected to the fifth respective shield pin, and
- the fourth shield at said other end of the cable being connected to the sixth respective shield pin.

Further, a secondary enhanced device for cooperating with the enhanced device for use in the system is arranged for cooperating with the further enhanced cable, the secondary enhanced device having a receptacle for receiving one of said connectors and secondary detection means for
- detecting, on a fifth receptacle pin, a third status of said fifth shield pin being either connected to ground or being not connected,
- detecting, on a sixth receptacle pin, a fourth status of said sixth shield pin being either connected to ground or being not connected, and
- detecting a cable status indicating the presence of either the standard cable or the enhanced cable connected between the enhanced device and a peer device based on the third and fourth status.

The arrangement of the enhanced device being coupled to the secondary enhanced device via the further enhanced cable enables detection of the connection status at both ends of the cable, i.e. in both devices independently. An example of such arrangement for data communication assumes one source device and one sink device. Advantageously both the source and the sink device can detect the connection status on respective connector pins. Moreover, the condition that two sink devices (or two source devices) are accidentally connected is detected similarly to no peer device being connected. This is due to the shield pins that are connected to the detecting means in one sink device are now connected via the cable to corresponding shield pins that are also connected to detecting means in the other sink device. Furthermore, as the crosswise arrangement of not connected pins can be done in two ways, the invention can be extended to encode more cable types i.e. each additional pair of shields multiplies the number of possible cables types that can be encode by 2.

Further preferred embodiments of the device and method according to the invention are given in the appended claims, disclosure of which is incorporated herein by reference.

### BRIEF DESCRIPTION OF THE DRAWINGS

These and other aspects of the invention will be apparent from and elucidated further with reference to the embodiments described by way of example in the following description and with reference to the accompanying drawings, in which
Fig. 1 shows a standard cable (also called legacy cable),
Fig. 2 shows an enhanced cable,
Fig. 3 shows an enhanced cable in reverse orientation,
Fig. 4 shows a detector for detecting an enhanced cable in an enhanced device,
Fig. 5 shows a further detector for detecting an enhanced cable in a secondary enhanced device,
Fig. 6 shows an eHDMI device connected to another eHDMI device via a standard HDMI cable,
Fig. 7 shows an eHDMI device connected to another eHDMI device via an eHDMI cable,
Fig. 8 shows an eHDMI device connected to a standard HDMI device via an enhanced HDMI cable,
Fig. 9 shows an eHDMI source device connected to an eHDMI source device, and
Fig. 10 shows a method for detecting a connection status.

In the Figures, elements which correspond to elements already described have the same reference numerals.

### DETAILED DESCRIPTION OF EMBODIMENTS

A data communication system has a standard cable and standard data communication devices, which are usually described in a standard specification. When further requirements for data communication have to be accommodated, an enhanced version of the specification is generated. New enhanced cables and enhanced devices are defined, while the existing standard devices and cables are usually called legacy cables and legacy devices. The legacy cable has standard connectors, and at least a first and a second shield, the first and second shields at the connectors being connected to respective shield pins of the connector pins. The shields are for reducing interference of electromagnetic radiation on sensitive communication wiring in the cable. Also standard devices exist that have a receptacle for receiving one of said connectors for connecting receptacle pins to connector pins. Examples of such devices are: a source device that generates data like a Blu-ray Disc™ player and, a sink device that receives data like a TV set, and a DVD recorder may be both source and sink device depending on the selected connection and function.

The data communication system is extended by an enhanced cable for enhanced connectivity with respect to the standard cable, e.g. by improving the data transmission parameters and/or shielding of the cable, adding extra connections, etc. In particular, the enhanced cable connectivity comprises a twisted pair of wires for carrying a high-speed data signal instead of standard ('straight') wires in the standard cable. Such a cable cannot be distinguished by testing the presence of conductors, but the cable type can properly be detected as proposed below. Also an enhanced device is provided.

The enhanced cable has the standard connectors and the same respective shield pins assigned corresponding to the assignment of shield pins in the standard cable. Hence the enhanced cable is compatible to the legacy cable, i.e. legacy devices can be connected using the enhanced cable. The enhanced cable has at least the same function as the standard cable, and includes the first and second shields.

However, contrary to the legacy cable, the following differences are included. The second shield is connected to the first shield, while in the legacy cable both shields are unconnected. Also, the first shield at one end of the cable is connected to the first respective shield pin (like the legacy cable), while the second shield at the same end of the cable is not connected to the second respective shield pin. Note that the second shield in the legacy is connected to the corresponding pin.

Furthermore, in the enhanced cable, the first shield at the other end of the cable is not connected to the third respective shield pin, while the second shield at said other end of the cable is connected to the fourth respective shield pin.

It is noted that the enhanced cable may also be provided for a system that currently has only one cable type, but may have further different cable types in the future. The presence of the enhanced cable can be detected now, while future different cable types may then be encoded and detected based on different combinations of shield pins being either connected to ground or being unconnected.

The enhanced device has a receptacle for receiving one of said connectors, similar to the legacy device. However, the enhanced device has detection circuitry for detecting the status of some shield pins, whereas the legacy device has all shield pins connected to ground. The connector pin status is being either connected to ground or being not connected. The detector elements are configured for detecting said status on at least two receptacle pins corresponding to connector shield pins that are either connected to ground or being not connected in the enhanced cable.

The detection elements may include first and second voltage level detectors coupled the receptacle pins and impedances coupled to a voltage source for detecting the first and second. The impedance may be a pull-up resistor or any suitable active or passive element to bring an unconnected connector pin within a predefined voltage range.

Based on said at least two status conditions, the connection status of the device to a peer device via a cable is determined, e.g. by a logic circuit. The peer device is the common denomination of a device coupled to, and able to communicate as intended, to the enhanced device. The connection status indicates the presence of either the standard cable or the enhanced cable connected between the enhanced device and a peer device based on the first and second status. It is noted that the shield is grounded via the peer device. Hence the connection status requires a peer device to be present. A separate peer present status can be based on the first and second status.

In an embodiment of the enhanced device the detection elements are arranged for determining, as the connection status, two separate status conditions based on the first and second status:
- a peer type status indicating the presence of a peer device of a predetermined type connected via the cable, and
- a cable type status indicating the presence of a cable of a predetermined type connected between the enhanced device and the peer device.

The enhanced cable may have identical connectors at both sides of the cable, if the corresponding standard cable is so defined. The enhanced cable is not fully symmetrical. Intentionally, the shield pins of said first and second shield are crosswise not connected. Hence the cable may be connected between devices in two orientations, called a normal orientation and a reverse orientation.

For such identical connectors the crosswise arrangement of not connected pins effectively allows always cable type detection, i.e. irrespective of the orientation of the cable. This is the result of one of the first and second pins being not grounded for the enhanced cable, while both pins are grounded for the standard cable. Hence the cable type can be reliably detected by combining the first and second status. Moreover, if required, said orientation of the cable can also be detected by detecting the status of a particular pin. For example the device may subsequently adapt the data communication, or request the user to reverse the cable. Furthermore, as the crosswise arrangement of not connected pins can be done in two ways, the invention can be extended to encode more cable types i.e. each additional pair of shields multiplies the number of possible cables types that can be encode by 2.

A further enhanced cable has further shields, e.g. at least third and fourth shields, the fourth shield being connected to the third shield. Similar to the first and second shield, the third shield at one end of the cable is connected to the fifth respective shield pin, the fourth shield at said one end of the cable is not connected to the sixth respective shield pin, the third shield at the other end of the cable is not connected to the seventh respective shield pin, and the fourth shield at said other end of the cable is connected to the eighth respective shield pin. Examples of such enhanced cables and different, but complementary enhanced devices, are discussed below for the HDMI casus.

In the further enhanced cable above, the first and second shields are preferably not connected to the third and fourth shields. If the shields were all connected, there could be confusion in the status detection. When the enhanced device of a sink type uses detection of the shield pin status on the first and second shield pins, the fifth en sixth pins must be grounded. Due to said unwanted connection of shields, at least one of the first and second pins would be grounded even when no peer device is connected at all. The erroneous ground detection is prevented when the first and second shields are not connected to the third and fourth shields.

A further enhanced device is complementary to the enhanced device described above that detects the connection status on the first and second shield pins. For example the primary enhanced device is a source device and the secondary device is a sink device that receives data from the source device. It is noted that such source and sink devices are so named based on their role in the data communications protocol, but may also communicate in both directions. However some of the interconnections on the interface may have dedicated transmitter and receiver circuitry for one-directional communication. The further (also called secondary) enhanced device is arranged for cooperating with the further enhanced cable above, and has a receptacle for receiving one of said connectors and secondary detection elements for detecting, a third and fourth status of said fifth and sixth shield pin being either connected to ground or being not connected. Based on the third and fourth status a connection status is determined that indicates the presence of either the standard cable or the enhanced cable connected between the secondary enhanced device and a peer device. Furthermore, based on the third and fourth status a peer connection status may be determined that indicates whether a peer is present or not.

The following sections will describe an example of the enhanced system in more detail and focuses on enhanced HDMI cable detection. Enhanced HDMI (eHDMI) augments the High-Definition Multimedia Interface (HDMI) with a high-speed, bi-directional data channel. eHDMI needs a dedicated cable that re-uses the HDP pin (pin 19 of the HDMI type A connector [1]) and the NC pin (pin 14) of HDMI for an additional (unshielded) twisted pair of wires for carrying the high-speed data signal. Therefore normal (legacy) HDMI cables are not suitable for eHDMI operation. The system includes a method for detecting whether a connected cable is an eHDMI cable or not. This can be used e.g. to warn the user that the cable is not suitable for eHDMI operation.

The HDMI standard has a mechanism called HPD (hot plug detect) to allow a source to detect whether a sink is connected or not. However the sink may control the HPD pin (for example to signal whether the EDID (extended display identification data) from a sink device can be read), which makes the detection of a peer device via the HPD mechanism unreliable. Preferably the eHDMI cable detection also allows a more reliable detection of a connected peer device.

The eHDMI detection method is based on whether shield pins of the HDMI cable that are normally connected to the shielding of a particular twisted pair of wires (shortly called: twisted pair) are connected to the shielding or not. The detection is done with a pull-up resistor and detection circuitry in the enhanced device. HDMI shields are always grounded. So, if the shield pin is connected, it cannot be pulled-up, because it is grounded (zero voltage). If it is not connected, it can be pulled-up by the resistor (non-zero voltage). This can be detected by the proposed detection circuitry.

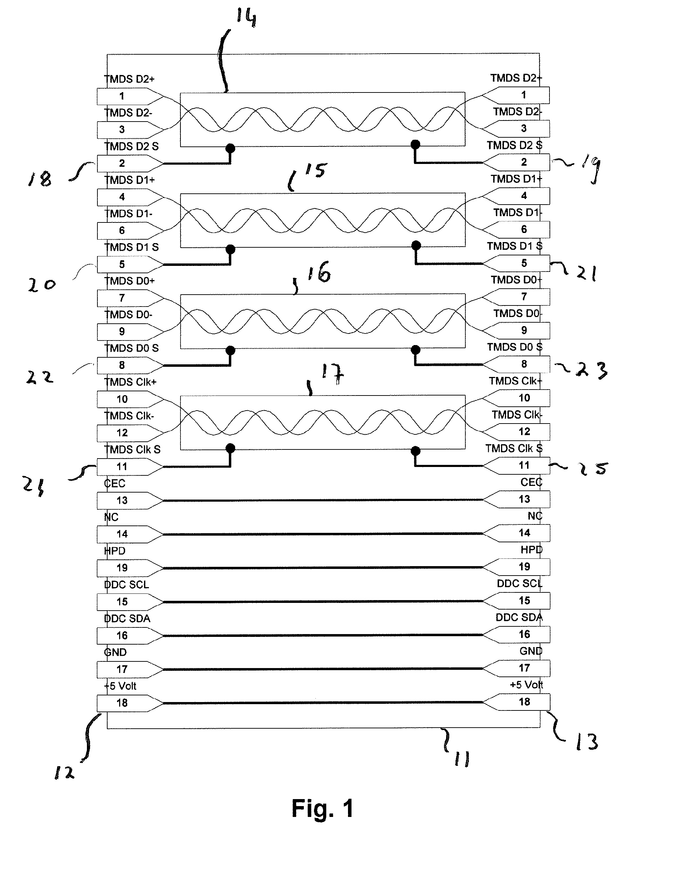

Figure 1 shows a legacy cable that has each shield pin connected to a shield. The legacy cable 11 has a first standard connector 12 and a second standard connector 13. The pin assignment is according to the HDMI standard [1] for the type A connector; the standard describes also further connector types. The legacy HDMI cable has always all shield pins 18,19,20,21,22,23,24,25 connected to a respective shield 14,15,16,17, i.e. they are always to be grounded in a receptacle of a HDMI device. Therefore the shield pins cannot be pulled-up. The shields each are formed around respective twisted pairs of leads to allow high speed data transfer. It is noted that the twisted pairs are drawn schematically, for example the wire from TMDS D2+ connects to TDMS D2+ on the other connector.

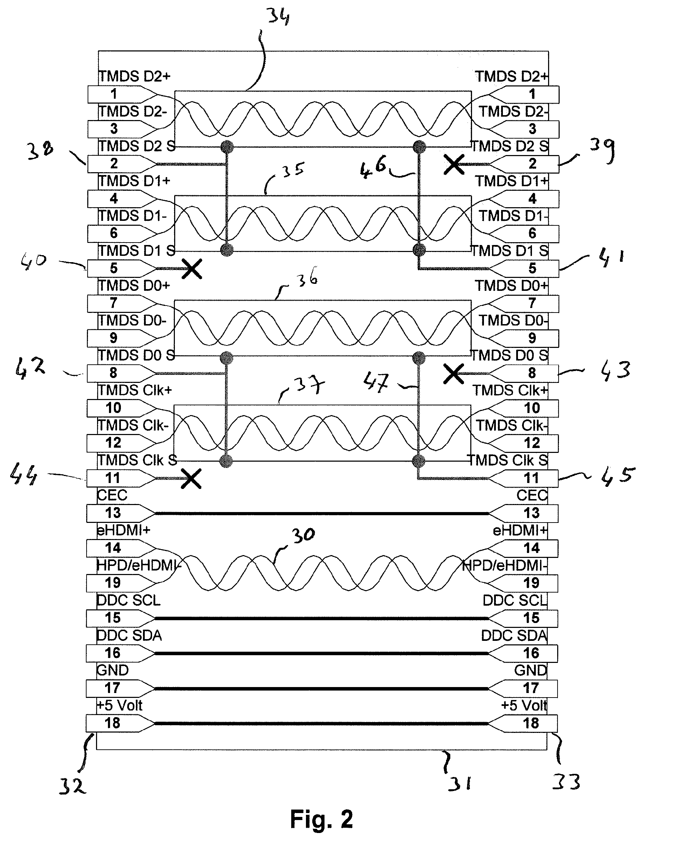

Figure 2 shows an enhanced cable that has some shield pins connected to a shield but others not connected. The enhanced cable 31 has a first standard connector 32 and a second standard connector 33. The pin assignment is according to the HDMI standard [1] type A connector. The proposed eHDMI cable has a number of unconnected shield pins 39,40,43,44 that can be pulled-up, while the further shield pins 38,41,42,45 are connected to the respective shields 34,35,36,37. In this way an eHDMI cable can be distinguished from a legacy HDMI one as explained below.

The first shield 34 is connected to the second shield 35 via connection 46. In practice the shields may connect either at one end, both ends or somewhere in between. The third shield 36 is connected to the fourth shield 37 via connection 47. Hence the shielding of each twisted pair is still grounded at each side of the eHDMI cable. Therefore the electrical characteristics of the eHDMI cable are (substantially) identical to the legacy HDMI cable. The additional twisted pair 30 for carrying the high-speed data signal is connected to the NC pin 14 and HPD pin 19 of the HDMI type A connector.

It is noted that, when the standard connectors at both ends of a cable are equal, the cable can be used in two directions. The standard cable is fully symmetrical and therefore has no orientation. The enhanced cable has different pin connections on both sides and therefore has two different orientations when in use between devices, called normal orientation and reverse orientation. The eHDMI cable has identical connectors on each end of the cable. Both orientations can be applied in the various use cases elucidated below. Figure 2 shows the eHDMI cable in normal orientation.

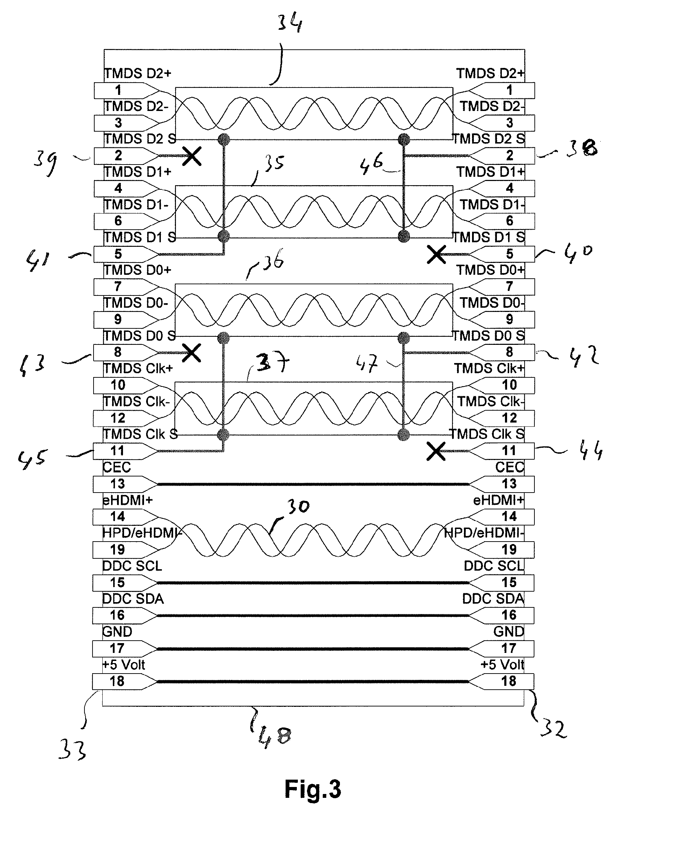

Figure 3 shows an enhanced cable in reverse orientation. The enhanced cable 48 in reverse orientation has the same elements as the cable 31 shown in Figure 2.

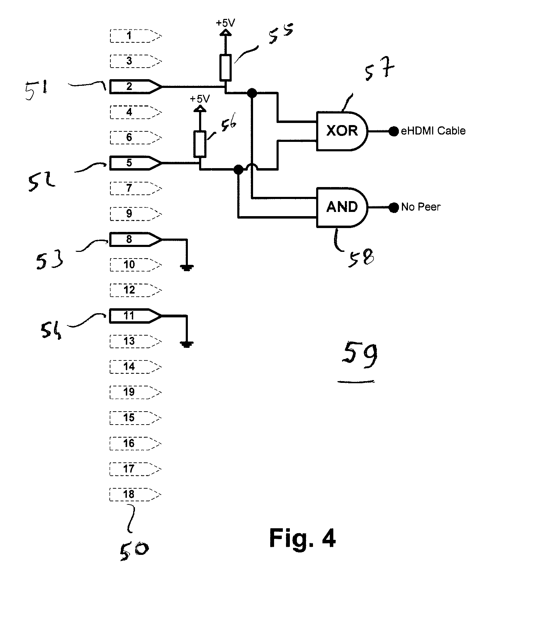

Figure 4 shows a detector for detecting an enhanced cable in an enhanced device. The enhanced device 59 has a receptacle 50 schematically indicated by the connector pins. The detector detects a first status of a first connector pin 51 via a pull-up resistor 55 to the voltage source of +5 Volt, and a second status of a second connector pin 52 via a pull-up resistor 56 to the voltage source of +5 Volt, via a voltage level sensitive logic XOR circuit 57 and a logic AND circuit 58. The XOR (exclusive or) circuit generates a high output signal called *eHDMI cable* when both inputs have a logically different status, which indicates the presence of an enhanced cable. The AND circuit generates a high output signal called *No Peer* when the both inputs have a logically high status, which indicates the absence of a peer device, i.e. the case shown in the Figure. The remaining shield pins 53,54 are grounded. The configuration shown in Figure 4 may be used in a sink device.

The XOR function flags that an eHDMI cable is connected if and only if exactly one of its inputs is pulled-up, otherwise it will flag that no eHDMI cable is connected. The logical AND function flags that No Peer is connected if all its inputs are pulled-up.

It is noted that, when no peer device is connected, the eHDMI Cable signal will be low, irrespective of any cable being connected. When the first and second shield 34,35 are connected in the enhanced cable to the third and fourth shield 36,37 the cable type could be distinguished from the legacy cable even when no peer is present, because one pin would be low due to the connection to the ground pin in the enhanced device itself. However the peer detection signal would not be available any more.

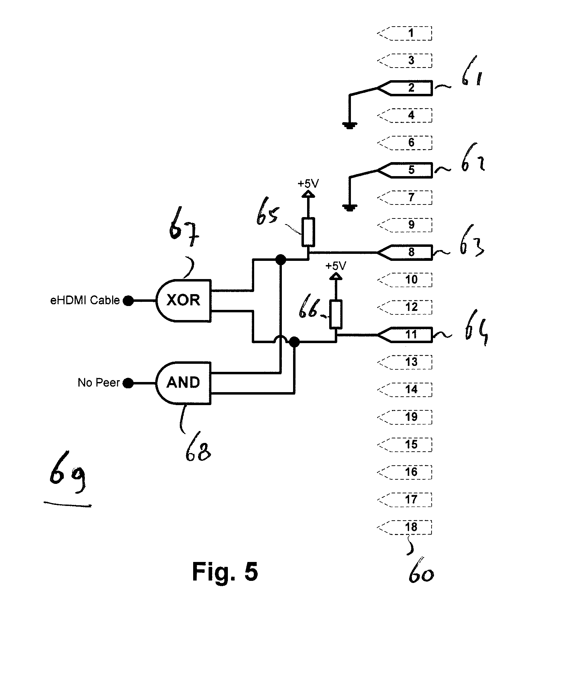

Figure 5 shows a further detector for detecting an enhanced cable in a secondary enhanced device. The secondary enhanced device 69 has a receptacle 60 schematically indicated by the connector pins. The detector detects a first status of a first connector pin 63 via a pull-up resistor 65 to the voltage source of +5 Volt, and a second status of a second connector pin 64 via a pull-up resistor 66 to the voltage source of +5 Volt, via a voltage level sensitive logic XOR circuit 67 and a logic AND circuit 68. The XOR (exclusive or) circuit generates a high output signal called *eHDMI cable* when the both inputs have a logically different status, which indicates the presence of an enhanced cable. The AND circuit generates a high output signal called *No Peer* when the both inputs have a logically high status, which indicates the absence of a peer device. The remaining shield pins 61,62 are grounded. The configuration shown in Figure 5 may be used in a HDMI source device.

Note that the eHDMI detection circuitry of the HDMI source is connected to other pins than the detection circuitry of the HDMI sink. Other implementations of the proposed eHDMI detection method are also possible, e.g. only one side has an eHDMI detection circuitry, other logical function are used e.g. OR, NOR, NAND etc. instead of XOR and AND or, other shielding pins are used by the eHDMI detection circuitry.

The following section indicates by a few examples that the proposed eHDMI method will detect correctly whether an eHDMI cable is connected or not in all foreseeable use cases.

When a legacy HDMI device is connected to another legacy HDMI device via an eHDMI cable, either in normal or reverse orientation, all pins are connected complying with the HDMI standard [1]. Hence the eHDMI cable operates like a legacy HDMI cable with legacy HDMI devices and "legacy" HDMI operation is possible.

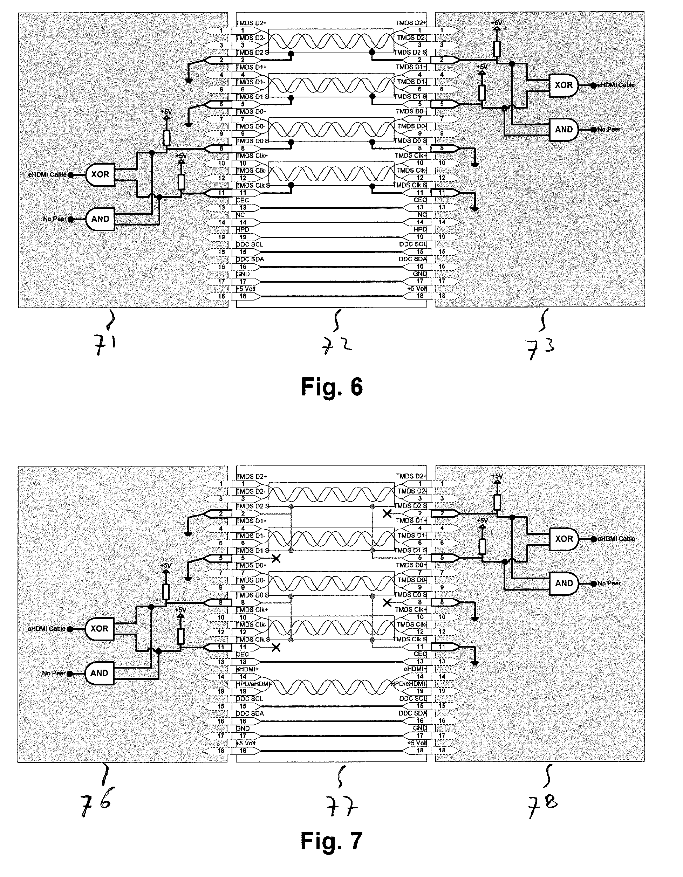

Figure 6 shows an eHDMI device connected to another eHDMI device via a legacy HDMI cable. The enhanced device 71 is connected via legacy cable 72 to enhanced device 73. The inputs of both XORs are all pulled-down, so that the eHDMI Cable signal on both sides are correctly de-asserted indicating that no eHDMI cable is connected.

When an eHDMI device is connected to a legacy HDMI device via a legacy HDMI cable, the inputs of the XOR are both pulled-down, so that the eHDMI Cable signal is correctly de-asserted indicating that no eHDMI cable is connected and a Peer device is present.

Figure 7 shows an eHDMI device connected to another eHDMI device via an eHDMI cable in normal orientation. The same result is achieved in reverse orientation. The enhanced device 76 is connected via enhanced cable 77 to enhanced device 78. Only one input of each XOR is pulled-up, so that the eHDMI Cable signal on both sides is correctly asserted indicating that the eHDMI devices are interconnected via an eHDMI cable, and the *No Peer* signal is low indicating that a peer device is connected.

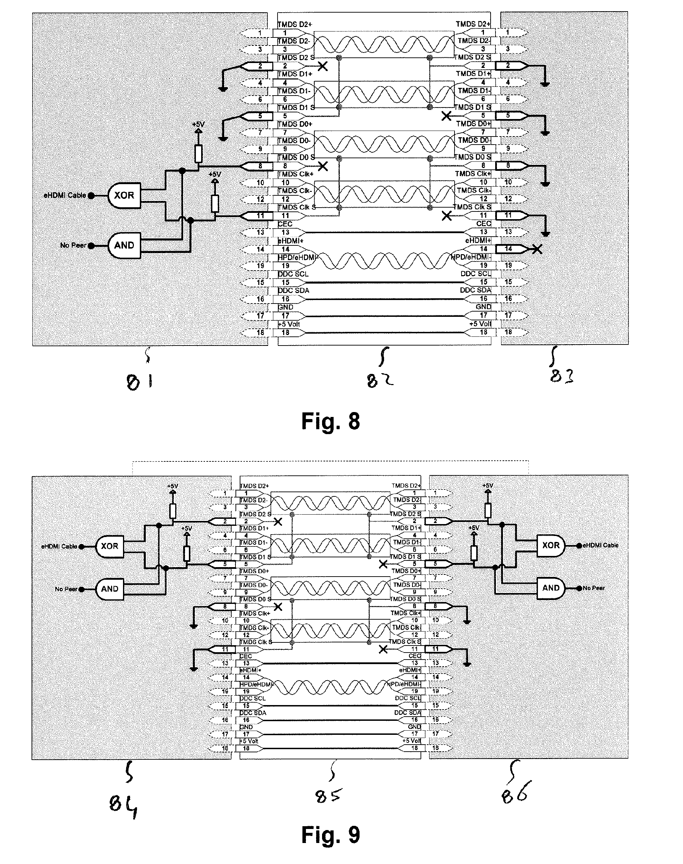

Figure 8 shows an eHDMI device connected to a legacy HDMI device via an enhanced HDMI cable. The enhanced device 81 is connected via enhanced cable 82 in reverse orientation to legacy device 83. The same result is achieved in normal orientation. In both cases only one input of the XOR is pulled-up, so that the eHDMI Cable signal is correctly asserted indicating that an eHDMI cable is connected. However, in this use case it must be signaled to the eHDMI device that its peer is not eHDMI capable in a different way, e.g. using data communication via the HDMI interface.

When a legacy HDMI device is connected to an eHDMI device via a legacy HDMI cable, the inputs of the XOR are both pulled-down, so that the eHDMI Cable signal is correctly de-asserted indicating that no eHDMI cable is connected.

When a legacy HDMI device is connected to an eHDMI device via an eHDMI cable (normal or reverse orientation), only one input of the XOR is pulled-up, so that the eHDMI Cable signal is correctly asserted indicating that an eHDMI cable is connected.

Figure 9 shows an eHDMI source device connected to an eHDMI source device. The enhanced source device 84 is connected via enhanced cable 85 (in reverse orientation) to enhanced source device 86. The same situation occurs for two sink devices, and in a loop-back, i.e. an enhanced device connected to itself via an eHDMI cable, or using a legacy cable. In all aforementioned use cases both inputs of the ANDs are pulled-up, so that the No Peer signals are correctly asserted indicating that the eHDMI device has no peer HDMI device.

The following table presents an overview of the use cases and the detection flags. The second and third column indicate the status of the output signals, which are not available (N.A.) for legacy devices.

| **Use Case** **(Source - Cable - Sink)** | **eHDMI** **(Source, Sink)** | **No Peer** **(Source, Sink)** | **Comments** |
|---|---|---|---|
| LEGACY HDMI DEVICE - eHDMI CABLE - LEGACY HDMI DEVICE | (N.A., N.A.) | (N.A., N.A.) | |
| eHDMI DEVICE - LEGACY CABLE - LEGACY HDMI DEVICE | (False, N.A.) | (False, N.A.) | |
| eHDMI DEVICE - eHDMI CABLE - LEGACY HDMI DEVICE | (True, N.A.) | (False, N.A.) | In this use case in one or another way it must be signaled to the eHDMI source device that its peer is not eHDMI capable. |
| LEGACY DEVICE - LEGACY CABLE - eHDMI DEVICE | (N.A., False) | (N.A., False) | |
| LEGACY DEVICE - eHDMI CABLE - eHDMI DEVICE | (N.A., True) | (N.A., False) | In this use case in one or another way it must be signaled to the eHDMI sink device that its peer is not eHDMI capable. |
| eHDMI DEVICE - LEGACY CABLE - eHDMI DEVICE | (False, False) | (False, False) | |
| eHDMI DEVICE - eHDMI CABLE - eHDMI DEVICE | (True, True) | (False, False) | Only in this use case proper eHDMI operation is possible. |
| eHDMI DEVICE - <NOT CONNECTED> | (False, False) | (True, True) | |
| eHDMI DEVICE - LEGACY CABLE - <NOT CONNECTED> | (False, False) | (True, True) | |
| eHDMI DEVICE - eHDMI CABLE - <NOT CONNECTED> | (False, False) | (True, True) | |
| eHDMI DEVICE - LEGACY CABLE - <LOOP BACK> | (False, False) | (True, True) | |
| eHDMI DEVICE - eHDMI CABLE - <LOOP BACK> | (False, False) | (True, True) | |

It is to be noted that the invention may be implemented in hardware and/or software, using programmable components. A dedicated processor or processor in a general purpose computer may be applied for executing a computer program that implements the following method.

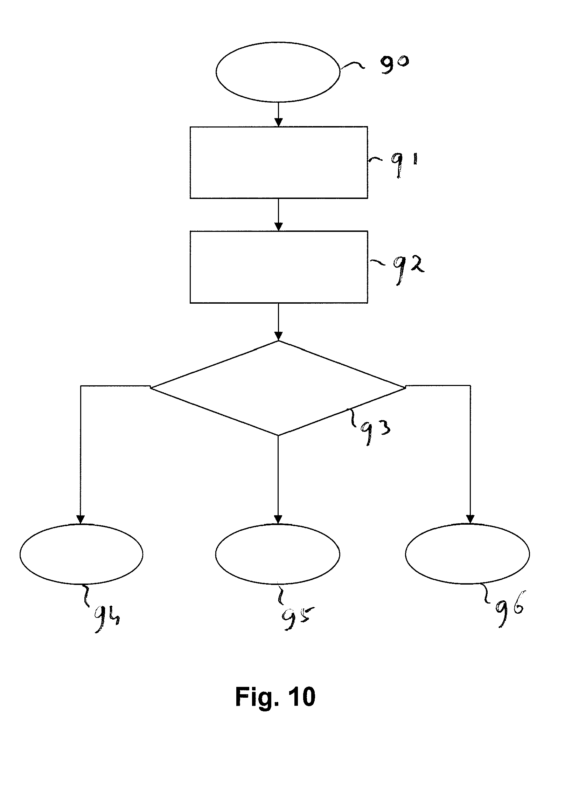

Figure 10 shows a method for detecting a connection status. The method is operable in the data communication system described above and starts at START 90 having the following steps. In a first step DETECT_A 91 on a first receptacle pin of a receptacle for receiving one of said connectors, a first status of said first shield pin is detected. The status is either connected to ground or being not connected. In a second step DETECT_B 92 on a second receptacle pin of the receptacle, a second status of said second shield pin is detected. Then in step DETERMINE 93 the connection status is determined based on the first and second status. A first connection status NO PEER 94 indicates that no peer device is connected, for example when both shield pin status indicate "not connected". A second connection status LEGACY CABLE CONNECTED TO PEER 95 indicates that a peer device is connected via a legacy cable, for example when both shield pin status indicate "grounded". A third connection status ENHANCED CABLE CONNECTED TO PEER 96 indicates that a peer device is connected via an enhanced cable, for example when one shield pin status indicates "grounded" and the other shield pin status indicate "not connected".

Although the invention has been mainly explained by embodiments using the HDMI interface standard, the invention is also suitable for any other interface standard that has at least two shields and corresponding shield pins on connectors on both ends of a cable. The enhanced cable detection can be applied to such standard interface, when it requires the addition of an enhanced cable type. Moreover, more than two cable types may be distinguished by using more shields that are either connected or not connected to corresponding shield pins. Cable types may be encoded using various combinations of not connected shield pins. The interface cable may further have different connectors at both sides, and/or the orientation may be predefined to be possible only in one direction. If so, the detection means may be adapted because it is known in advance which pin may be not connected.

It is noted, that in this document the word 'comprising' does not exclude the presence of other elements or steps than those listed and the word 'a' or 'an' preceding an element does not exclude the presence of a plurality of such elements, that any reference signs do not limit the scope of the claims, that the invention may be implemented by means of both hardware and software, and that several 'means' or 'units' may be represented by the same item of hardware or software, and a processor may fulfill the function of one or more units, possibly in cooperation with hardware elements. Further, the invention is not limited to the embodiments, and the invention lies in each and every novel feature or combination of features described above.

## Claims

1. A system, comprising:
a standard cable (11) having standard connectors (12,13), the cable comprising at least a first and a second shield (14,15), the first and second shields at the connectors being connected to respective shield pins (18,19,20,21) of the connector pins,
a standard device (83) having a receptacle for receiving one of said connectors for connecting receptacle pins to connector pins;
wherein the system comprises:
an enhanced cable (31) for enhanced connectivity with respect to the standard cable, having
- connectors (32,33) having respective shield pins assigned corresponding to the assignment of shield pins in the standard cable,
- the first and second shields (34,35), the second shield being connected (46) to the first shield,
- the first shield (34) at one end of the cable being connected to the first respective shield pin (38),
- the second shield (35) at said one end of the cable being not connected to the second respective shield pin (40),
- the first shield (34) at the other end of the cable being not connected to the third respective shield pin (39), and
- the second shield (35) at said other end of the cable being connected to the fourth respective shield pin (41); and
an enhanced device (59) having a receptacle (50) for receiving one of said connectors and detection means (55,56,57,58) for
- detecting, on a first receptacle pin (51), a first status of said first shield pin being either connected to ground or being not connected,
- detecting, on a second receptacle pin (52), a second status of said second shield pin being either connected to ground or being not connected, and
- determining a connection status indicating the presence of either the standard cable or the enhanced cable connected between the enhanced device and a peer device based on the first and second status.

2. Enhanced cable for use in the system of claim 1 for enhanced connectivity with respect to the standard cable, having
- connectors (32,33) having respective shield pins assigned corresponding to the assignment of shield pins in the standard cable,
- the first and second shields (34,35), the second shield being connected (46) to the first shield,
- the first shield (34) at one end of the cable being connected to the first respective shield pin (38),
- the second shield (35) at said one end of the cable being not connected to the second respective shield pin (40),
- the first shield (34) at the other end of the cable being not connected to the third respective shield pin (39), and
- the second shield (35) at said other end of the cable being connected to the fourth respective shield pin (41).

3. Enhanced cable as claimed in claim 2, wherein the connectors (32,33) at both sides of the cable are identical.

4. Enhanced cable as claimed in claim 2, wherein the enhanced cable has
- third and fourth shields, the fourth shield (37) being connected to the third shield (36),
- the third shield at one end of the cable being connected to the fifth respective shield pin (42),
- the fourth shield at said one end of the cable being not connected to the sixth respective shield pin (44),
- the third shield at the other end of the cable being not connected to the seventh respective shield pin (43), and
- the fourth shield at said other end of the cable being connected to the eighth respective shield pin (45).

5. Enhanced cable as claimed in claim 4, wherein
- the first and second shields are not connected to the third and fourth shields.

6. Enhanced cable as claimed in claim 2, wherein the enhanced connectivity comprises a twisted pair (30) of wires for carrying a high-speed data signal instead of standard wires in the standard cable.

7. Enhanced device for use in the system of claim 1 having a receptacle (50) for receiving one of said connectors and detection means (55,56,57,58) for
- detecting, on a first receptacle pin (51), a first status of said first shield pin being either connected to ground or being not connected,
- detecting, on a second receptacle pin (52), a second status of said second shield pin being either connected to ground or being not connected, and
- determining a connection status indicating the presence of either the standard cable or the enhanced cable connected between the enhanced device and a peer device based on the first and second status.

8. Enhanced device as claimed in claim 7, wherein the detection means are arranged for determining, as the connection status,
- a peer status indicating the presence of a peer device of a predetermined type connected via the cable based on the first and second status, and
- a cable type status indicating the presence of a cable of a predetermined type connected between the enhanced device and the peer device based on the first and second status.

9. Enhanced device as claimed in claim 7, wherein the detection means (55,56,57,58) comprises:
- a first voltage level detector (57) coupled to the first receptacle pin and a first impedance (55) coupled to a voltage source for detecting the first status, and
- a second voltage level detector (58) coupled to the second receptacle pin and a second impedance (56) coupled to a voltage source, for detecting the second status.

10. Secondary enhanced device for cooperating with the enhanced device (59) as claimed in claim 7 for use in the system of claim 1, wherein the secondary enhanced device (69) is arranged for cooperating with the enhanced cable as claimed in any of the claims 4 or 5, the secondary enhanced device having a receptacle (60) for receiving one of said connectors and secondary detection means (65,66,67,68) for
- detecting, on a fifth receptacle pin (63), a third status of said fifth shield pin being either connected to ground or being not connected,
- detecting, on a sixth receptacle pin (64), a fourth status of said sixth shield pin being either connected to ground or being not connected, and
- determining a connection status indicating the presence of either the standard cable or the enhanced cable connected between the secondary enhanced device and a peer device based on the third and fourth status.

11. Method of detecting a connection status in a system comprising:
a standard cable having standard connectors, the cable comprising at least a first and a second shield, the first and second shields at the connectors being connected to respective shield pins of the connector pins,
a standard device having a receptacle for receiving one of said connectors for connecting receptacle pins to connector pins;
wherein the system comprises:
an enhanced cable for enhanced connectivity with respect to the standard cable, having
- the standard connectors having respective shield pins assigned corresponding to the assignment of shield pins in the standard cable,
- the first and second shields, the second shield being connected to the first shield,
- the first shield at one end of the cable being connected to the first respective shield pin,
- the second shield at said one end of the cable being not connected to the second respective shield pin,
- the first shield at the other end of the cable being not connected to the third respective shield pin, and
- the second shield at said other end of the cable being connected to the fourth respective shield pin; and
the method comprises:
- detecting, on a first receptacle pin of a receptacle for receiving one of said connectors, a first status of said first shield pin being either connected to ground or being not connected,
- detecting, on a second receptacle pin of the receptacle, a second status of said second shield pin being either connected to ground or being not connected, and
- determining a connection status indicating the presence of either the standard cable or the enhanced cable connected to a peer device based on the first and second status.

12. Computer program product for detecting a connection status in a system as claimed in claim 1, which program is operative to cause a processor to perform the method as claimed in claim 11.
